# FASCICULE DE BREVET EUROPEEN

(11) **EP 1 680 829 B1**
(45) Date de publication et mention de la délivrance du brevet: **12.09.2012**
(21) Numéro de dépôt: 04805421.7
(22) Date de dépôt: 09.11.2004
(51) Int. Cl.: H01M 4/66, H01M 4/485, H01M 6/18, H01M 10/0562, H01M 4/58

(54) **ELECTROLYTE SOLIDE, NOTAMMENT POUR CELLULE ELECTROCHIMIQUE EN COUCHES MINCES, ET UN PROCEDE DE FABRICATION**
FESTELEKTROLYT INSBESONDERE FÜR EINE ELEKTROCHEMISCHE DÜNNSCHICHTZELLE UND HERSTELLUNGSVERFAHREN
SOLID ELECTROLYTE, IN PARTICULAR FOR A THIN LAYER ELECTROCHEMICAL CELL AND PRODUCTION METHOD

(30) Priorité: 14.11.2003 FR 0313378
(43) Date de publication de la demande: 19.07.2006
(73) Titulaire: H.E.F., 42160 Andrezieux-Boutheon (FR)
(72) Inventeur: MARTIN, Michel, 38780 Septeme (FR); BLANDENET, Olivier, F-38240 Meylan (FR)
(74) Mandataire: Quantin, Bruno Marie Henri
(86) Numéro de dépôt international: PCT/FR2004/002878
(87) Numéro de publication internationale: WO 2005/050764

(56) Documents cités:
- FR-A- 2 428 617
- US-A- 4 164 610
- US-A- 4 668 593
- US-A1- 2003 118 897
- US-B1- 6 432 584

## Description

L'invention concerne un électrolyte solide, notamment utilisable dans des cellules électrochimiques en couches minces.

Des exemples de telles cellules électrochimiques sont donnés dans les documents FR-2 638 764 ou FR-2 762 448 (ou dans leurs équivalents US-5 202 201 et US-6 355 376).

Ces cellules comportent un substrat, par exemple en verre ou en silicium, recouvert d'une couche collectrice de courant (par exemple en platine ou en chrome), d'une couche d'oxysulfure de titane (le soufre pouvant être remplacé par Se ou Te), d'une couche d'électrolyte en verre conducteur ionique, et d'une couche de lithium constituant une électrode négative.

Dans ces documents, des enseignements sont donnés sur le matériau constitutif de l'électrode positive, à savoir la couche d'oxysulfure de titane ; plus précisément il est enseigné des valeurs quant aux proportions relatives d'oxygène et de soufre.

L'électrolyte solide utilisé dans ces exemples est un borate de lithium particulier, à base d'oxydes de bore (B203), d'oxyde de lithium (LiO2) et de sels de lithium (dont les anions sont par exemple des halogénures ou des sulfates), dont la formule est 1 B2O3 ; 0,8 Li2O ; 0,8 Li2SO4.

Il est rappelé ici que l'électrolyte solide doit jouer deux rôles essentiels : être un excellent isolant électronique entre les deux électrodes, et être un bon conducteur ionique, vis-à-vis de l'ion en cause, ici Li+.

En fait, l'électrolyte peut se révéler un élément tout à fait critique pour les performances d'une cellule électrochimique. En ce qui concerne une batterie secondaire en couches minces, il est ainsi important d'obtenir une bonne réversibilité lors des cycles de charge/décharge (donc une bonne capacité à supporter un grand nombre de cycles de charge et de décharge) ainsi qu'une bonne stabilité dans le temps (conservation de sa charge au cours du temps, ainsi que des autres propriétés électrochimiques et mécaniques).

Il est en outre, bien sûr, important d'avoir l'énergie la plus élevée possible.

Il faut aussi que la couche ait une bonne résistance mécanique, pour pouvoir résister à d'éventuelles déformations lors de la constitution de la cellule électrochimique ou lors de son utilisation, en conservant ses propriétés au cours du temps.

Il y a en outre des applications où l'on a besoin de satisfaire aux diverses conditions précitées avec des cellules de très petite taille.

Dans le domaine des piles en couches minces, le document US - 5 338 625 (ainsi que les documents US - 5 512 147, US - 5 567 210, US - 5 597 660 et US - 6 218 049 qui ont la même description) a proposé un nouvel électrolyte qui est électrochimiquement stable et qui ne réagit pas avec l'anode en lithium, en combinaison avec une cathode en oxyde de vanadium. Il s'agit d'orthophosphate de lithium (Li3PO4) déposé sous atmosphère d'azote, ce qui donne une couche vitreuse de LixPOyNz, avec x égal à 2.8 environ, le terme 2y+3z égal à de l'ordre de 7.8, et z compris entre 0.16 et 0.46. Dans l'exemple considéré dans ce document l'épaisseur de cette couche est de l'ordre du micron. Il est expliqué à propos de cet électrolyte qu'il combine une conductivité ionique élevée et une grande stabilité vis-à-vis de l'anode de lithium : l'azote est présenté comme étant responsable, malgré une teneur d'à peine 2 à 6% atomiques, de l'augmentation de la conductivité dans un rapport d'au moins 5 vis-à-vis de films analogues sans azote, ainsi que de la stabilité vis-à-vis de l'anode : une conductivité de 2,4 à 3,3 10-⁶ S/cm a été observée.

Le même genre d'électrolyte solide est proposé dans le document US- 5 612 152, qui concerne un empilement de piles élémentaires.

En raison des noms abrégés des composants de cette couche (Li, P, O et N), le matériau constitutif de celle-ci est parfois appelée « Lipon »

On connaît également, d'après le document FR-2 428 617, des conducteurs cationiques dont le composant essentiel est B2O3 ; la composition de l'un d'entre eux est B₂O₃ ; 0,57 Li₂O ; 0,14 Li₃PO₄.

A l'usage, le lipon est apparu avoir une conductivité ionique de l'ordre de 10 fois supérieure à celle d'un électrolyte Li2O-Li2SO4-B2O3 tel que celui décrit dans les documents FR-2 638 764 et FR-2 762 448 précités. Malheureusement, il est aussi apparu présenter une tenue mécanique médiocre, conduisant, en conséquence des opérations d'élaboration, à des contraintes internes se traduisant fréquemment par des phénomènes d'écaillage et de fissuration pouvant ruiner les performances de la cellule électrochimique considérée.

L'invention a pour objet un nouvel électrolyte, combinant une valeur élevée de conductivité ionique et une bonne tenue mécanique, notamment en flexion, permettant de minimiser les phénomènes catastrophiques tels que l'écaillage ou la fissuration.

L'invention propose à cet effet un électrolyte solide pour cellule électrochimique en couches minces, dont la composition est :
- B, à une teneur atomique comprise entre 0.001 et 0.20,
- P, à une teneur atomique comprise entre 0.05 à 0.15,
- N, à une teneur atomique comprise entre 0.02 et 0-18,
- Li, à une teneur atomique comprise entre 0.20 et 0.50,
- O, à une teneur atomique comprise entre 0.35 et 0.50,
le total des teneurs étant sensiblement égal à 1.

Selon des caractéristiques préférées, éventuellement combinées :
- la teneur en bore est comprise entre 0,006 et 0,14
- la teneur en phosphore est comprise entre 0,09 et 0,12
- la teneur en azote est comprise entre 0.04 et 0,12
- la teneur en lithium est comprise entre 0.30 et 0.45
- la teneur en oxygène est comprise entre 0,39 et 0,45

L'invention propose en outre une cellule électrochimique comportant des couches minces formant respectivement:
- une électrode collectrice,
- une cathode,
- un électrolyte solide vitreux du type précité,
- une anode.

Il mérite d'être noté ici que ce qui précède a été exposé dans le cas d'une cellule électrochimique au lithium.

Selon des caractéristiques préférées, éventuellement combinées :
- l'électrode collectrice est en titane, avec de préférence une épaisseur de l'ordre de 0,1 à 0,5 microns, avantageusement 0,2 microns,
- la cathode est en oxysulfure de titane, avec de préférence une épaisseur de l'ordre de 1 à 5 microns, avantageusement environ 1,5 microns,
- l'électrolyte a de préférence une épaisseur sensiblement égale à celle de la cathode, de l'ordre de 0,5 à 2 microns, avantageusement environ 1,5 microns,
- l'anode est en lithium, avec de préférence une épaisseur de l'ordre de la somme des épaisseurs de la cathode et de l'électrolyte, par exemple de l'ordre de 2 à 6microns, avantageusement environ 3 microns.
- l'épaisseur globale est d'environ 6 microns,
- les couches sont déposées sur un substrat de silicium ou sur un substrat de silicium dont une couche de passivation est SiO₂ ou Si₃N₄.

L'invention propose en outre un procédé de préparation d'un élément électrochimique selon lequel on réalise une couche d'électrolyte solide par pulvérisation sur un substrat, sous azote, d'un matériau composite de (Li3PO4)a ; (B2O3)b ; (Li2O)c, où a≥0,5, b≥0,025 et c≥0,025 avec a+b+c = 1.

De manière avantageuse, la pulvérisation est une pulvérisation cathodique magnétron haute fréquence, dans des conditions classiques de durée et de température notamment pour des dépôts de lipon), par exemple pendant de 60 à 120 minutes, à une température comprise entre100 et 150°C sous une pression d'azote comprise entre 0,4 Pa et 4 Pa.

Des objets, caractéristiques et avantages de l'invention ressortent de la description qui suit, concernant divers exemples de réalisation, conformes ou non aux enseignements de l'invention.

Un électrolyte solide selon l'invention est avantageusement obtenu à partir d'une cible composite de (Li₃PO₄)ₐ ; (B₂O₃)_{b} ; (Li₂O)_{c} où a≥0,5, b ≥0,025, c≥0,025 avec a+b+c = 1. Cette cible est de préférence pulvérisée sous azote par pulvérisation cathodique magnétron haute fréquence, ce qui a pour effet de faire diminuer le taux d'oxygène et de faire apparaître un peu d'azote dans la composition, jusqu'à un taux maximum d'environ 18 %.

On peut noter que, par rapport au lipon qui est formé à partir du seul orthophosphate, la cible utilisée ici est formée pour au plus 95% d'orthophosphate, et pour au moins 5% d'oxydes de bore ou d'oxyde de lithium (le rapport de la teneur d'oxyde de bore à la teneur d'oxyde de lithium est de préférence compris entre 0,05 et 19)

Ainsi que cela ressort des exemples qui suivent, l'addition de ces oxydes de lithium et de bore permet de conserver de bons niveaux de conductivité ionique, tout en supprimant, de manière inattendue, les problèmes de contraintes internes susceptibles de dégrader, de façon éventuellement catastrophique, la tenue mécanique en service.

### Exemple n°1 : conforme à l'invention

On fabrique un lot de 100 micro-batteries dont la surface élémentaire est de 2 cm² en déposant successivement :
- une électrode collectrice en titane de 0,2 µm d'épaisseur,
- une cathode en oxysulfure de titane de 1,5 µm d'épaisseur,
- un électrolyte vitreux de composition Li_{0,38}P_{0,12}B_{0,006}O_{0,43}N_{0,06} d'épaisseur 1,5 µm,
- une anode en lithium d'épaisseur 3µm,

La composition de l'électrolyte vitreux correspond aux valeurs suivantes, en ce qui concerne la cible de départ :
- a = 0,95,
- b = 0,025,
- c = 0,025.

Ces quatre couches sont réalisées par dépôt physique en phase vapeur. La couche d'électrolyte est réalisée par pulvérisation cathodique magnétron haute fréquence, pendant une durée de 90 minutes, à une température 130°C, sous une pression d'azote de 0,8 Pa.

On teste ensuite ces batteries en mesurant leur tension de sortie avant et après les avoir soumises à un test de flexion selon la norme ISO 7816. On constate que, avant test de flexion, 90 % des microbatteries ont une tension à vide supérieure à 2,4 volts. Après test de flexion, ce chiffre passe à 85 %, les batteries restantes avant une tension comprise entre 0 et 2 volts. Le taux de rebut, avant test de flexion, est conforme à celui auquel on peut s'attendre avec ce type de fabrication, avec du lipon normal (sans bore). Les batteries ainsi réalisées ont remarquablement résisté à la flexion puisque seules 5 % ont été affectées par ce test. Les contraintes internes de l'électrolyte mesurées par déflexion sur un témoin en silicium sont de l'ordre de -50 Mpa.

### Exemple n° 2 : non conforme à l'invention

On fabrique un lot de 100 microbatteries dont la surface élémentaire est de 2 cm² en déposant successivement :
- une électrode collective en titane de 0,2 µm d'épaisseur,
- une cathode en oxysulfure de titane de 1,5 µm d'épaisseur,
- un électrolyte vitreux de composition Li_{0,38}P_{0,13}O_{0,43}N_{0,06} d'épaisseur 1,5 µm,
- une anode en lithium d'épaisseur 3 µm.

La composition de l'électrolyte vitreux correspond aux valeurs suivantes, en ce qui concerne la cible de départ :
- a = 1,00,
- b = 0,00,
- c = 0,00.

Ces quatre couches sont réalisées par dépôt physique en phase vapeur dans les mêmes conditions que celles de l'exemple 1 puis elles sont testées de la même manière.

Avant test de flexion, on constate que 80 % des micro-batteries ont une tension à vide supérieure à 2,4 volts. Après test de flexion, ce chiffre n'est plus que de 20 %, les batteries restantes ayant une tension comprise entre 0 et 2 volts.

Cet électrolyte, dénué de présence de bore, conduit d'une part à une fiabilité moins bonne du procédé de fabrication, et d'autre part à une fragilité plus importante des microbatteries ainsi réalisées. Ce résultat peut être imputé aux contraintes internes du LiPON qui, mesurées de la même manière que dans l'exemple 1, sont à un niveau double, soit -100 Mpa.

### Exemple n° 3 : conforme à l'invention

Pour mesurer la conductivité ionique de l'électrolyte des microbatteries, on réalise par pulvérisation cathodique sous vide un dispositif particulier constitué d'une électrode de titane de 0,2 µm d'épaisseur, d'un dépôt d'électrolyte de 1,5 µm d'épaisseur, et enfin d'une seconde électrode de titane de 0,2 µm d'épaisseur sur un substrat silicium. On encapsule ensuite l'ensemble par une couche contenant du nitrure de silicium réalisée par PECVD (Plasma Enhanced Chemical Vapor Deposition, en anglais) de façon à pouvoir manipuler l'ensemble à l'air ambiant sans risque de dégradation de la cellule de mesure. La mesure de conductivité de l'électrolyte a été réalisée selon la méthode d'impédance complexe classiquement utilisée pour ce type de matériau.

Dans le cadre de cet exemple, l'électrolyte réalisé a la composition Li_{0,44}P_{0,09}B_{0,01}O_{0,39}N_{0,07}. Cela correspond, pour la cible de départ, aux valeurs suivantes :
- a = 0,50,
- b = 0,475,
- c = 0,025.

Sur 100 systèmes réalisés, la moyenne des valeurs de conductivité ionique de l'électrolyte à 25°C est de 5x10⁻⁶ Scm⁻¹, avec un écart type de 1x10⁻⁶ Scm⁻¹.

Une telle valeur est tout à fait satisfaisante ; par comparaison avec celle mentionnée dans les documents précités à propos du lipon, à savoir 2,40 10⁻⁶ S/cm à 3,30 10⁻⁶ S/cm, on constate que l'addition du bore et l'augmentation de la teneur en lithium se traduisent par une amélioration de la conductivité ionique.

### Exemple n° 4 : non conforme à l'invention

On procède de la même manière que l'exemple n°3 mais l'électrolyte a la composition Li_{0,38} P_{0,13}O_{0,43}N_{0,06} et on mesure de la même manière la conductivité ionique des couches déposées sur un lot de 100 échantillons. La conductivité ionique moyenne de l'électrolyte à 25°C est de 3x10⁻⁶ Scm⁻¹, avec un écart type de 2x10⁻⁶ Scm⁻¹. Les valeurs de conductivité ionique obtenues avec le LiPON sont donc plus faibles que celles de l'électrolyte contenant du bore de l'exemple 3. On constate aussi un écart-type double pour l'électrolyte sans bore comparé à l'électrolyte qui contient du bore. Le bore, quoiqu'en très faible quantité, a un effet stabilisant sur l'électrolyte.

### Exemple n° 5 : non conforme à l'invention

On procède de la même manière que l'exemple n° 3 mais l'électrolyte a la composition Li_{0,18}P_{0,11}B_{0,21}O_{0,42}N_{0,08} (ce qui correspond à des valeurs a = 0,20, b = 0,60 et c = 0,20) et on mesure de la même manière la conductivité ionique des couches déposées sur un lot de 100 échantillons. La conductivité ionique moyenne de l'électrolyte à 25° C est de 4x10⁻⁷ Scm⁻¹, avec un écart-type de 2x10⁻⁷ Scm⁻¹. Quand le taux de bore devient trop élevé la conductivité ionique diminue beaucoup.

### Exemple n° 6 : conforme à l'invention

On fabrique un lot de 100 microbatteries dont la surface élémentaire est de 25 mm² sur silicium recouvert d'une couche de passivation de Si3N4 réalisé en PECVD en déposant successivement :
- une électrode collectrice en titane de 0,2 µm d'épaisseur,
- une cathode en oxysulfure de titane de 1,5 µm d'épaisseur,
- un électrolyte vitreux de composition Li_{0,23}P_{0,07}B_{0,14}O_{0,44}N_{0,12} d'épaisseur 1,5 µm,
- une anode en lithium d'épaisseur 3 µm.

Cet électrolyte vitreux est obtenu à partir d'une cible ayant les valeurs a = 0,50, b = 0,475 et c = 0,025.

Ces quatre couches sont réalisées par dépôt physique en phase vapeur et sont suivies d'une couche protectrice contenant du Si₃N₄ de 0,5 µm.

On observe les microbatteries ainsi réalisées et on ne constate pas d'écaillage. Le niveau de contraintes internes, lors du dépôt préserve l'intégrité mécanique de la couche.

On teste ensuite ces batteries en mesurant leur tension de sortie avant et après les avoir soumises à un test de vieillissement selon la norme ISO 4586-2 :1997. On constate que, avant test de vieillissement, 95 % des microbatteries ont une tension à vide supérieure à 2,4 volts. Après test de vieillissement, ce chiffre passe à 82 %, les batteries restantes ayant une tension comprise entre 0 et 2 volts et laissant apparaître des piqûres. Le taux de rebut, avant test de vieillissement, est conforme à celui auquel on peut s'attendre avec ce type de fabrication. Les batteries ainsi réalisées conformément à l'invention résistent remarquablement bien au vieillissement puisque seules 13 % ont été affectées par ce test.

### Exemple n°7 : non conforme à l'invention.

On fabrique un lot de 100 microbatteries de la même façon que dans l'exemple 6. Toutefois l'électrolyte de l'exemple 7 a la composition Li_{0,37}P_{0,13}O_{0,43}N_{0,06}.

On observe les microbatteries ainsi réalisées et on constate que 50 % présentent des écaillages. Cette composition d'électrolyte induit donc des contraintes internes néfastes.

On teste ensuite ces batteries en mesurant leur tension de sortie avant et après les avoir soumises à un test de vieillissement selon la norme ISO 4586-2:1997. On constate que, avant test de vieillissement, 50 % des microbatteries ont une tension à vide supérieure à 2,4 volts. Après test de vieillissement, ce chiffre passe à 0 %, toutes les batteries ayant une tension comprise entre 0 et 2 volts et laissent apparaître des piqûres et des délaminations. Le taux de rebut, avant test de vieillissement, est beaucoup plus élevé que celui auquel on peut s'attendre avec ce type de fabrication. Les batteries ainsi réalisées ont très mal résisté au vieillissement puisque toutes ont été affectées par ce test. En comparaison de l'exemple 6, on constate que le bore y a apporté un effet stabilisant inattendu vis-à-vis de cet exemple 7.

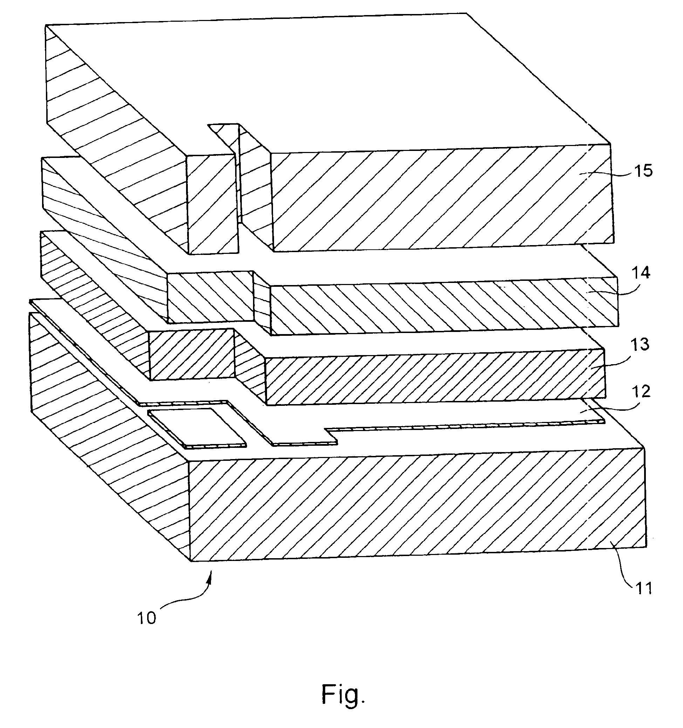

La figure unique décrit un exemple de cellule électrochimique conforme à l'invention.

Sa structure permet d'identifier son procédé de fabrication.

Cette cellule 10 comporte un substrat 11, par exemple en silicium, une couche collectrice de courant 12, ici en titane, une cathode 13, ici en oxysulfure de titane, un électrolyte vitreux 14 selon l'un quelconque des bons exemple précités, une anode 15 de préférence en lithium.

La couche 12 a ici une épaisseur de 0.2 micron, la cathode une épaisseur de 1.5 micron, la couche d'électrolyte une épaisseur de 1.5 micron et l'anode une épaisseur de 3 microns.

## Revendications

1. Electrolyte solide vitreux pour cellule électrochimique en couches minces, dont la composition est :
- B, à une teneur atomique comprise entre 0.001 et 0.20,
- P, à une teneur atomique comprise entre 0.05 à 0.15,
- N, à une teneur atomique comprise entre 0.02 et 0.18,
- Li, à une teneur atomique comprise entre 0.20 et 0.50,
- O, à une teneur atomique comprise entre 0.35 et 0.50,
le total des teneurs étant sensiblement égal à 1.

2. Electrolyte selon la revendication 1, **caractérisé en ce que** la teneur en bore est comprise entre 0,006 et 0.14

3. Electrolyte selon la revendication 1 ou la revendication 2, **caractérisé en ce que** la teneur en phosphore est comprise entre 0,09 et 0.12 .

4. Electrolyte selon l'une quelconque des revendications 1 à 3 **caractérisé en ce que** la teneur en azote est comprise entre 0,04 et 0,12.

5. Electrolyte selon l'une quelconque des revendications 1 à 4, **caractérisé en ce que** la teneur en lithium est comprise entre 0,30 et 0,45.

6. Electrolyte selon l'une quelconque des revendications 1 à 5, **caractérisé en ce que** la teneur en oxygène est comprise entre 0,39 et 0,45.

7. Cellule électrochimique comportant des couches minces formant respectivement:
- une électrode collectrice,
- une cathode,
- un électrolyte solide vitreux selon l'une quelconque des revendications 1 à 6,
- une anode.

8. Cellule électrochimique selon la revendication 7, **caractérisée en ce que** l'anode est en lithium.

9. Cellule selon la revendication 7 ou la revendication 8, **caractérisée en ce que** l'épaisseur de l'anode est comprise entre 2 et 6 microns.

10. Cellule selon l'une quelconque des revendications 7 à 9, **caractérisée en ce que** l'épaisseur de l'électrolyte solide est comprise entre 0,5 et 2 microns, environ.

11. Cellule selon l'une quelconque des revendications 7 à 10, **caractérisée en ce que** la cathode est en oxysulfure de titane.

12. Cellule selon l'une quelconque des revendications 7 à 11, **caractérisée en ce que** la cathode a une épaisseur comprise entre 1 et 5 microns, environ.

13. Cellule selon l'une quelconque des revendications 7 à 12, **caractérisée en ce que** l'électrode collectrice de courant est en titane.

14. Cellule selon l'une quelconque des revendications 7 à 13, **caractérisée en ce que** son épaisseur est de l'ordre de 6 microns.

15. Cellule selon l'une quelconque des revendications 7 à 14, **caractérisée en ce qu'**elle est réalisée sur un substrat de silicium ou sur un substrat de silicium dont une couche de passivation est SiO₂ ou Si₃N₄.

16. Procédé de préparation d'un électrolyte solide selon lequel on réalise une couche par pulvérisation sur un substrat, sous azote, d'un matériau composite de (Li3PO4)a ; (B2O3)b ; (Li2O)c, où a≥0,5, b≥0,025 et c≥0,025 avec a+b+c = 1.

17. Procédé selon la revendication 16, **caractérisé en ce que** la pulvérisation est une pulvérisation cathodique magnétron haute fréquence.

## Claims

1. Glassy solid-state electrolyte for a thin-film electrochemical cell, the composition of which is:
- B with a content of between 0.001 and 0.20 at%;
- P with a content of between 0.05 and 0.15 at%;
- N with a content of between 0.02 and 0.18 at%;
- Li with a content of between 0.20 and 0.50 at%; and
- O with a content of between 0.35 and 0.50 at%, the total of the contents being approximately equal to 1.

2. Electrolyte according to claim 1, **characterised in that** the boron content is between 0.006 and 0.14.

3. Electrolyte according to claim 1 or claim 2, **characterised in that** the phosphorus content is between 0.09 and 0.12.

4. Electrolyte according to any one of claims 1 to 3, **characterised in that** the nitrogen content is between 0.04 and 0.12.

5. Electrolyte according to any one of claims 1 to 4, **characterised in that** the lithium content is between 0.30 and 0.45.

6. Electrolyte according to any one of claims 1 to 5, **characterised in that** the oxygen content is between 0.39 and 0.45.

7. Electrochemical cell comprising thin films that form, respectively:
- a collector electrode;
- a cathode;
- a glassy solid-state electrolyte according to any one of claims 1 to 6; and
- an anode.

8. Electrochemical cell according to claim 7, **characterised in that** the anode is made of lithium.

9. Cell according to claim 7 or claim 8, **characterised in that** the thickness of the anode is between 2 and 6 microns.

10. Cell according to any one of claims 7 to 9, **characterised in that** the thickness of the solid-state electrolyte is between 0.5 and 2 microns, approximately.

11. Cell according to any one of claims 7 to 10, **characterised in that** the cathode is made of titanium oxysulfide.

12. Cell according to any one of claims 7 to 11, **characterised in that** the cathode has a thickness of between 1 and 5 microns, approximately.

13. Cell according to any one of claims 7 to 12, **characterised in that** the current collector electrode is made of titanium.

14. Cell according to any one of claims 7 to 13, **characterised in that** its thickness is around 6 microns.

15. Cell according to any one of claims 7 to 14, **characterised in that** it is produced on a silicon substrate or on a silicon substrate that includes an SiO₂ or Si₃N₄ passivation film.

16. Process for producing a solid-state electrolyte, in which a film is produced on a substrate by sputtering, in nitrogen, of a composite material comprising: (Li₃PO₄)ₐ; (B₂O₃)_{b}; (Li₂O)_{c}, where a ≥ 0.5, b ≥ 0.025 and c ≥ 0.025 and a+b+c = 1.

17. Process according to claim 16, **characterised in that** the sputtering is high-frequency magnetron cathode sputtering.

## Patentansprüche

1. Glasartiger Festelektrolyt für elektrochemische Dünnschichtzellen, dessen Zusammensetzung wie folgt ist:
- B mit einem Atomgehalt zwischen 0,001 und 0,20,
- P mit einem Atomgehalt zwischen 0,05 bis 0,15,
- N mit einem Atomgehalt zwischen 0,02 und 0,18,
- Li mit einem Atomgehalt zwischen 0,20 und 0,50,
- O mit einem Atomgehalt zwischen 0,35 und 0,50,
wobei der Gesamtgehalt etwa gleich 1 ist.

2. Elektrolyt nach Anspruch 1, **dadurch gekennzeichnet**, das der Borgehalt zwischen 0,006 und 0,14 liegt.

3. Elektrolyt nach Anspruch 1 oder Anspruch 2, **dadurch gekennzeichnet, dass** der Phosphorgehalt zwischen 0,09 und 0,12 liegt.

4. Elektrolyt nach einem der Ansprüche 1 bis 3, **dadurch gekennzeichnet, dass** der Stickstoffgehalt zwischen 0,04 und 0,12 liegt.

5. Elektrolyt nach einem der Ansprüche 1 bis 4, **dadurch gekennzeichnet, dass** der Lithiumgehalt zwischen 0,30 und 0,45 liegt.

6. Elektrolyt nach einem der Ansprüche 1 bis 5, **dadurch gekennzeichnet, dass** der Sauerstoffgehalt zwischen 0,39 und 0,45 liegt.

7. Elektrochemische Zelle, umfassend dünne Schichten, welche jeweils bilden:
- eine Niederschlagselektrode,
- eine Kathode,
- einen glasartigen Festelektrolyten nach einem der Ansprüche 1 bis 6,
- eine Anode.

8. Elektrochemische Zelle nach Anspruch 7, **dadurch gekennzeichnet, dass** die Anode aus Lithium ist.

9. Elektrochemische Zelle nach Anspruch 7 oder Anspruch 8, **dadurch gekennzeichnet, dass** die Dicke der Anode zwischen 2 und 6 Mikron ist.

10. Elektrochemische Zelle nach einem der Ansprüche 7 bis 9, **dadurch gekennzeichnet, dass** die Dicke des Festelektrolyten etwa zwischen 0,5 und 2 Mikron ist.

11. Elektrochemische Zelle nach einem der Ansprüche 7 bis 10, **dadurch gekennzeichnet, dass** die Kathode aus Titanoxysulfid ist.

12. Elektrochemische Zelle nach einem der Ansprüche 7 bis 11, **dadurch gekennzeichnet, dass** die Kathode eine Dicke zwischen etwa 1 bis 5 Mikron aufweist.

13. Elektrochemische Zelle nach einem der Ansprüche 7 bis 12, **dadurch gekennzeichnet, dass** die leitende Niederschlagselektrode aus Titan ist.

14. Elektrochemische Zelle nach einem der Ansprüche 7 bis 13, **dadurch gekennzeichnet, dass** ihre Dicke in der Größenordnung von 6 Mikron ist.

15. Elektrochemische Zelle nach einem der Ansprüche 7 bis 14, **dadurch gekennzeichnet, dass** sie auf einem Siliciumsubstrat oder auf einem Siliciumsubstrat mit einer Passivierungsschicht von SiO₂ oder Si₃N₄ hergestellt wird.

16. Verfahren zur Herstellung eines Festelektrolyten, wobei eine Schicht durch Zerstäubung eines Verbundwerkstoffes aus (Li₃PO₄)ₐ : (B₂O₃)_{b} : (Li₂O)_{c} auf einem Substrat, ohne Stickstoff, hergestellt wird, wobei a ≥ 0,5, b ≥ 0,025 und c ≥ 0,025, mit a+b+c=1.

17. Verfahren nach Anspruch 16, **dadurch gekennzeichnet, dass** die Zerstäubung eine Hochfrequenz-Magnetronkathoden-Zerstäubung ist.
